# EUROPÄISCHE PATENTSCHRIFT

(11) **EP 1 440 349 B1**
(45) Veröffentlichungstag und Bekanntmachung des Hinweises auf die Patenterteilung: **15.06.2005**
(21) Anmeldenummer: 02802276.2
(22) Anmeldetag: 29.10.2002
(51) Int. Cl.: G03F 7/40, H01L 21/311, H01L 21/3213

(54) **VERFAHREN ZUR HERSTELLUNG EINER HALBLEITERVORRICHTUNG**
METHOD FOR THE PRODUCTION OF A SEMICONDUCTOR DEVICE
PROCEDE DE PRODUCTION D'UN DISPOSITIF A SEMI-CONDUCTEURS

(30) Priorität: 31.10.2001 DE 10154966
(43) Veröffentlichungstag der Anmeldung: 28.07.2004
(73) Patentinhaber: Infineon Technologies AG, 81669 München (DE)
(72) Erfinder: ROGALLI, Michael, 84056 Rottenburg (DE); REB, Alexander, 01109 Dresden (DE); VOELKEL, Lars, 01309 Dresden (DE); STEGEMANN, Maik, 01157 Dresden (DE)
(74) Vertreter: Gross, Felix, Dr.
(86) Internationale Anmeldenummer: PCT/DE2002/004062
(87) Internationale Veröffentlichungsnummer: WO 2003/038528

(56) Entgegenhaltungen:
- EP-A- 1 117 008
- WO-A-01/29879
- WO-A-99/19903
- US-A- 5 869 404
- US-A- 6 010 966

## Beschreibung

Jährlich werden im Halbleiter-Geschäft Kostenreduktionen von bis zu 30% notwendig, um bei dem ständigen Preisverfall noch einen Gewinn zu erzielen. Traditionell erfolgt die notwendige Kostenreduktion durch Verkleinerung der Halbleiterstrukturen, insbesondere im Speicherbereich.

Eine Verkleinerung der Strukturgrössen ist durch Verringerung der Wellenlänge des Lichtes bei der Lithographie möglich. Derzeit beträgt die Wellenlänge des Lichtes bei DUV-Belichtung ("deep ultraviolet"-Belichtung) 248 nm. In der nächsten Generation wird die Wellenlänge bei 193 nm liegen.

Gängige Lithographieverfahren umfassen generell einen Belichtungsschritt, gefolgt von einem Entwicklungsschritt und einem Ätzschritt. Beim Ätzen wird die in den vorangegangenen Belichtungs- und Entwicklungsschritten hergestellte Struktur auf ein Substrat übertragen, beispielsweise zur Erzeugung von Leiterbahnen. Dazu wird die Substratoberfläche einem Plasma ausgesetzt, das mit dieser reagiert und dadurch die unbelichteten Strukturen abträgt.

Ein generelles Problem bei der Lithographie ist die Herstellung von rauhen Kanten im Lackprofil. Bei der Ätzung wird das Lackprofil und damit auch dessen rauhe Kanten "übernommen", d.h. auf die darunterliegende Schicht abgebildet. Aufgrund fehlender Seitenwandpassivierung tritt ausserdem sogenanntes "Bowing" auf, d.h. dass die Kanten des Lackprofils abgerundet sind. Ausserdem weist der Lack nach dem Ätzen Beschädigungen auf.

Dieses Problem tritt bei der 193nm-Lithographie stärker auf, als bei der herkömmlichen 248nm-Lithographie. Dies liegt daran, dass bei der 193nm-Lithographie andere Lacke verwendet werden müssen, als für die 248nm-Lithographie. Anstatt aromatischer Komponenten werden aliphatische und cycloaliphatische Systeme eingesetzt. Im Vergleich zu den aromatischen Lacken weisen diese Systeme generell eine ungleichmässigere Kantenbildung sowie eine geringere thermische Stabilität auf.

Eine naheliegende Gegenmassnahme wäre, die Kathodentemperatur beim Ätzen zu reduzieren. Ausserdem könnten Ätzgase verwendet werden, die Fluorin enthalten. Solche Gase verursachen generell eine chemische Reaktion, die eine Seitenwandpassivierung herbeiführen können. Versuche mit diesen Gegenmassnahmen sind jedoch gescheitert.

Die vorliegende Erfindung hat zur Aufgabe, die oben geschilderte Problematik zumindest abzumindern. Diese Aufgabe wird durch die in den unabhängigen Ansprüchen angegebene Erfindung gelöst. Vorteilhafte Ausgestaltungen sind den Unteransprüchen zu entnehmen.

Erfindungsgemäss ist ein Verfahren geschaffen zur Herstellung einer Halbleitervorrichtung unter Verwendung eines Substrates, auf dem eine photoempfindliche Schicht sowie eine darunter liegende zu strukturierende Schicht aufgebracht sind, mit folgenden Schritten:
Belichten der photoempfindlichen Schicht durch eine Maske; Entwickeln der belichteten photoempfindlichen Schicht zur Bildung von Maskierungsstrukturen;
Selektives Abtragen von unmaskierten Bereichen der zu strukturierenden Schicht mittels eines Ätzgases, das ein reaktives Monomer enthält.

Das Halbleitersubstrat kann zusätzliche zwischen oder auf den besagten Schichten verlaufende Schichten enthalten.

Das reaktive Monomer kann ein Alkin, ein Alkinderivat, ein Ehtin, oder ein Ethinderivat sein.

Weiterhin wird ist das Verfahren mit Vorteil in einem Lithographieverfahren einsetzbar, in dem der Belichtungsschritt mit Licht mit einer Wellenlänge von 193 nm verwendet durchgeführt wird.

Erfindungsgemäss ist ausserdem ein Ätzgas geschaffen zum Ätzen einer zu strukturierenden Schicht eines Halbleitersubstrates bei der Herstellung einer Halbleitervorrichtung, wobei das Ätzgas ein reaktives Monomer enthält.

Wie bereits in Bezug auf das erfindungsgemässe Verfahren erwähnt kann das reaktive Monomer ein Alkin, ein Alkinderivat, ein Ethin, ein Ethinderivat, ein sein.

Durch Verwendung eines reaktiven Monomeres als Teil des bzw. Zusatz zum Ätzgas werden eine Polymerisation (Passivierung) der Seitenwände des Lackes und dadurch eine Bildung ungesättigter Strukturen an der Lackoberfläche erreicht. Die erwähnte Problematik des "Bowing" sowie der rauhen Kanten des Lackes wird weitestgehend beseitigt. Mittels Polymerisation eines Zusatzes im Ätzgas (nämlich des reaktiven Monomers) wird somit der gleiche Effekt erreicht, wie bei der 248nm-Lithographie mittels Verwendung eines aromatischen Lackes. Damit sind nun auch durch eine 193nm-Lithographie Chipstrukturen herstellbar, die in der Qualität denen mittels 248nm-Lithographie hergestellten entsprechen. Folglich werden eine weitere Miniaturisierung und damit einhergehend eine Erhöhung der Wirschaftlichkeit bzw. Produktivität bei der Chipherstellung erreicht.

Die Erfindung wird nun anhand eines Ausführungsbeispieles in Bezug auf die Zeichnungen erklärt, und es zeigen:
- Figur 1: die chemischen Strukturen der Lacksysteme für die 248nm-Lithographie (links) und die 193nm-Lithographie (rechts); und
- Figur 2: einen schematischen Querschnitt durch die Schichtstruktur bei der Herstellung einer Halbleitervorrichtung.

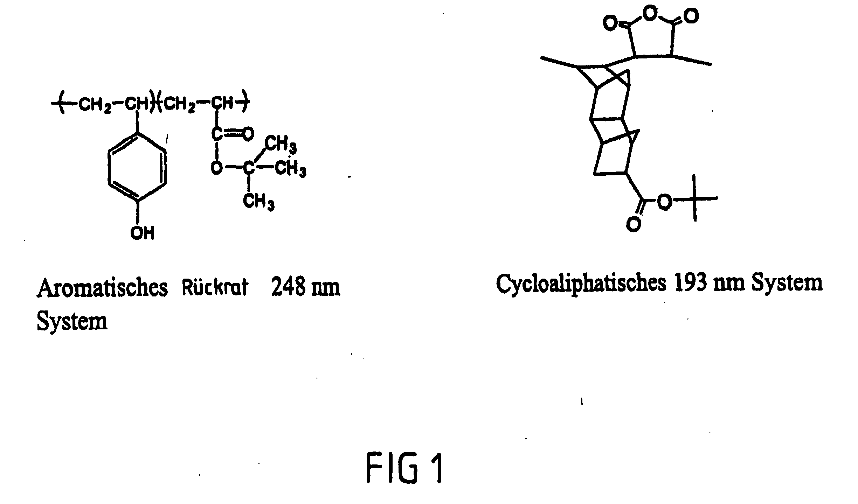

Figur 1 illustriert links die chemische Struktur eines Lackes, der in der 248nm-Lithographie eingesetzt wird.
Rechts ist die chemische Struktur eines Lackes für die 193nm-Lithographie gezeigt. Im Gegensatz zum 248nm-System hat dieser Lack wie oben beschrieben den Nachteil, dass dieser bei der Ätzung keine Bildung einer Passivierungsschicht anregt.

Dieses Defizit wird dadurch ausgeglichen, dass das Ätzgas einen Zusatz eines reaktiven Monomers enthält, wie beispielsweise ein Alkin oder ein Alkinderivat. Dies hat zur Folge, dass bei der Ätzung ungesättigte Strukuren an der Oberfläche erzeugt werden, analog zur Ätzung des 248nm-Lackes. Dies hat die Bildung einer Passivierungsschicht zur Folge. Durch den Zusatz von reaktiven Monomeren zum Ätzgas werden demnach die Ätzbedingungen eines 248nm-Systems in einem 193nm-System hergestellt.

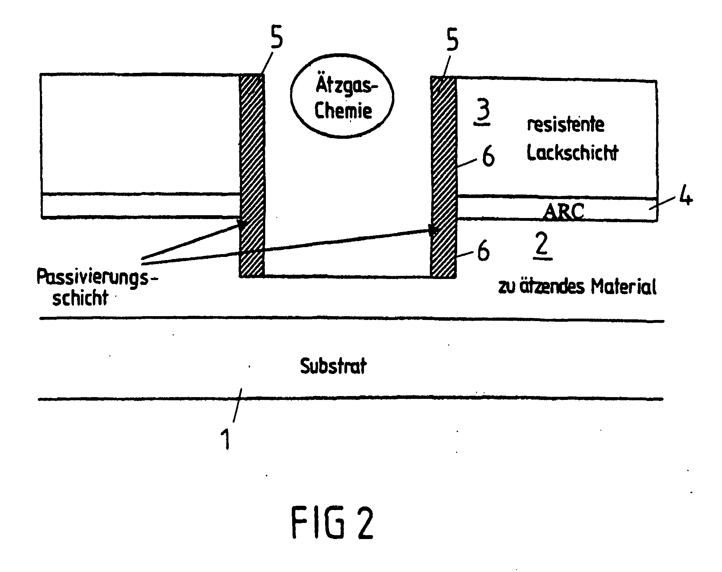

Figur 2 zeigt schematisch die Schichten bei der Herstellung einer Halbleitervorrichtung. Auf einem Substrat 1 ist eine zu ätzende Schicht 2 aufgebracht. Darüber verläuft eine Lackschicht 3. Die Lackschicht 3 ist generell resistent gegnenüber einer Ätzung der Schicht 2. Zwischen der Lackschicht 3 und der zu ätzenden Schicht 2 verläuft ausserdem eine antireflektive Schicht 4 (ARC).

Figur 2 zeigt weiterhin eine Passivierungsschicht 5, die durch Polymerisation des reaktiven Monomers gebildet wird. Die Passivierungsschicht 5 schützt die Seitenwände 6 des Lackes 3 sowie der zu ätzenden Schicht 2. Dadurch werden diese vor isotropen Beschädigungen bewahrt.

Anzumerken ist, dass die Erfindung nicht auf die beschriebenen Ausführungsbeispiele beschränkt ist, sondern Modifikationen im Rahmen des durch die Ansprüche festgelegten Schutzbereiches umfasst.

## Patentansprüche

1. Verfahren zur Herstellung einer Halbleitervorrichtung unter Verwendung eines Substrates, auf dem eine photoempfindliche Schicht sowie eine darunter liegende zu strukturierende Schicht aufgebracht sind, mit folgenden Schritten:
- Belichten der photoempfindlichen Schicht durch eine Maske, wobei Licht mit einer Wellenlänge von 193 nm verwendet wird;
- Entwickeln der belichteten photoempfindlichen Schicht zur Bildung von Maskierungsstrukturen;
- Selektives Abtragen von unmaskierten Bereichen der zu strukturierenden Schicht mittels eines Ätzgases, das ein reaktives Monomer enthält.

2. Verfahren nach Anspruch 1, wobei das reaktive Monomer ein Alkin oder Alkinderivat ist.

3. Verfahren nach Anspruch 1, wobei das reaktive Monomer ein Bthin oder Ethinderivat ist.

4. Verwendung von Ätzgas zum Ätzen einer zu strukturierenden Schicht auf einem Substrat bei der Herstellung einer Halbleitervorrichtung in einem Lithographieverfahren mit Licht einer Wellenlänge von 193 nm, wobei das Ätzgas ein reaktives Monomer enthält.

5. Verwendung von Ätzgas nach Anspruch 4, wobei das reaktive Monomer ein Alkin oder Alkinderivat ist.

6. Verwendung von Ätzgas nach Anspruch 4, wobei das reaktive Monomer ein Ethin oder Ethinderivat ist.

## Claims

1. A process for the production of a semiconductor apparatus using a substrate on which a photosensitive layer and a layer to be structured and present underneath are applied, comprising the following steps:
- exposure of the photosensitive layer through a mask, light having a wavelength of 193 nm being used;
- development of the exposed photosensitive layer for the formation of masking structures;
- selective removal of material of unmasked parts of the layer to be structured, by means of an etch gas which contains a reactive monomer.

2. A process as claimed in claim 1, the reactive monomer being an alkyne or alkyne derivative.

3. A process as claimed in claim 1, the reactive monomer being an ethyne or ethyne derivative.

4. The use of etch gas for etching a layer to be structured on a substrate in the production of a semiconductor apparatus in a lithography process using light having a wavelength of 193 nm, the etch gas containing a reactive monomer.

5. The use of etch gas as claimed in claim 4, the reactive monomer being an alkyne or alkyne derivative.

6. The use of etch gas as claimed in claim 4, the reactive monomer being an ethyne or ethyne derivative.

## Revendications

1. Procédé de production d'un dispositif à semi-conducteur en utilisant un substrat sur lequel est déposée une couche photosensible ainsi qu'une couche sous-jacente à structurer comprenant les stades:
- insolation de la couche photosensible à travers un masque en utilisant de la lumière d'une longueur d'onde de 193 nm;
- développement de la couche photosensible isolée pour former des structures de masquage;
- enlèvement sélectif de parties non masquées de la couche à structurer au moyen d'un gaz d'attaque, qui contient un monomère réactif.

2. Procédé suivant la revendication 1, dans lequel le monomère réactif est une alcyne ou un dérivé d'alcyne.

3. Procédé suivant la revendication 1, dans lequel le monomère réactif est une éthyne ou un dérivé d'éthyne.

4. Utilisation de gaz d'attaque pour attaquer une couche à structurer sur un substrat lors de la production de dispositif à semi-conducteur dans un procédé de lithographie par de la lumière d'une longueur d'onde de 193 nm, dans lequel le gaz d'attaque contient un monomère réactif.

5. Utilisation de gaz d'attaque suivant la revendication 4, dans lequel le monomère réactif est une alcyne ou un dérivé d'alcyne.

6. Utilisation de gaz d'attaque suivant la revendication 4, dans lequel le monomère réactif est une éthyne ou un dérivé d'éthyne.
